# EUROPEAN PATENT SPECIFICATION

(11) **EP 2 487 326 B1**
(45) Date of publication and mention of the grant of the patent: **28.03.2018**
(21) Application number: 11153780.9
(22) Date of filing: 09.02.2011
(51) Int. Cl.: E21B 41/00, E21B 47/01, H05K 7/20

(54) **Subsea electronic system**
Unterwasserelektroniksystem
Système électronique sous-marin

(43) Date of publication of application: 15.08.2012
(73) Proprietor: Siemens Aktiengesellschaft, 80333 München (DE)
(72) Inventor: Boe, Ove, 7549, Tanem (NO)

(56) References cited:
- WO-A1-2008/055515
- WO-A2-2011/009022
- GB-A- 1 600 095
- US-A- 4 331 830
- US-A1- 2008 302 115
- 'Comparing naturally cooled horizontal baseplate heat sinks with vertical baseplate heat sinks', [Online] 24 March 2004, pages 1 - 7, XP055153048 Retrieved from the Internet: <URL:http://www.thermalsoftware.com/vert_vs _horz_sink.pdf> [retrieved on 2014-11-14]

## Description

### Filed of the invention

The invention relates to a subsea electronic system comprising a pressure resistant enclosure adapted to maintain a predetermined pressure inside the enclosure when the system is deployed under water.

### Background of the invention

In offshore oil or gas production, drilling rigs or oil platforms are generally used. In the operation of offshore oil platforms, it can be necessary to install electronics under water, e.g. for controlling functions of a subsea Christmas tree or a subsea blowout preventer. Recently, subsea wells are being established in which more and more production equipment is relocated to the sea floor. Electronic components are required for both power supply and control. It needs to be ensured that the installed equipment operates reliability even under the high pressures exerted by the sea water at great depths of water of e.g. more than 1000 or even 2000 meters.

Electronic components, such as power electronics are for example installed by placing the components in a canister with an internal pressure of approximately one atmosphere (close to 1 bar). For this purpose the canisters are provided with a thick wall in order to withstand the pressure at the sea floor. This thick wall represents a high resistance to the heat losses of the electronic components located inside the canister. In addition, the thermal conductivity of the materials used is generally relatively poor. Accordingly, in operation, heat accumulates in the canister and there is a risk that the electronics is overheating.

Generally, there are two types of enclosures that can be used for encapsulating electrical or mechanical equipment. Besides using the above mentioned pressure resistant enclosures, which are capable of maintaining an inside pressure of one atmosphere, pressure compensated enclosures are known in which the internal pressure is approximately matched to the external pressure exerted on the enclosure when deployed under water. Such pressure compensated enclosures can be provided with thinner walls which improves the heat transfer. Yet another problem is that some electrical components cannot be operated at such high pressures, making such pressure compensated enclosures unsuitable for housing such components.

WO 2011/009022 A2 discloses an apparatus of heat dissipaters for electronic components in downhole tools. The electronic components are received in a housing, and a thermally conductive flowable material is provided in the housing and is in thermal communication with the components.

US2008/0302115 A1 discloses a combined pressure compensator and cooling unit, in which a first container comprising electronic equipment and a second container are provided. The volume of the second container can be increased to contain the increased volume of heated cooling fluid.

A possibility of improving the heat dissipation from the electronic component is to increase the surface of the canister, e.g. by increasing its size. Yet such an approach will attract higher production costs and also lead to an increase of the wall thickness.

### Summary

Accordingly, there is a need for a subsea electronic system which provides an efficient cooling of electronic components, and which is capable of employing electronic components that are not adapted for operation at subsea pressure levels. This need is met by the features of the independent claims. The dependent claims describe preferred embodiments of the invention.
According to an aspect of the invention, a subsea electronic system comprising a pressure resistant enclosure is provided. The pressure resistant enclosure is adapted to maintain a predetermined pressure inside the enclosure when the system is deployed under water. The system further comprises a heat generating electronic component arranged in the enclosure, the electronic component generating heat in operation. Furthermore, a dielectric liquid is provided which at least partially fills the enclosure. The subsea electronic system is configured such then the subsea electronic system is deployed underwater in an operating state, the electronic component is at least partially submerged in the dielectric liquid and the dielectric liquid is in contact with at least one wall of the enclosure, so as to enable a transfer of heat from the heat generating electronic component to the at least one wall of the enclosure via the dielectric liquid.
By means of the dielectric liquid, an effective cooling of the heat generating electronic component can be achieved. According to the invention, generated heat can be transported efficiently to the enclosure wall and can on the other side of the wall be taken up by surrounding seawater. With such an arrangement, even a large amount of heat produced by the electronic component can be dissipated. By providing the system with a pressure resistant enclosure which maintains a predetermined pressure inside, pressure sensitive electronic components can be used without compromising their functionality. Furthermore, as the efficient cooling the electronic component by means of the dielectric liquid leads to a decreased operating temperature of the electronic component, the reliability of the electronic component may be improved and its lifetime increased.
In an embodiment of the system, the enclosure is further partially filled with a gas or a gas mixture. By providing a small amount of gas or gas mixture inside the enclosure, it can be ensured that the inside pressure is maintained at the predefined value even if the enclosure is slightly deformed, e.g. due to high outside pressures. This is due to the compressibility of gas, for which a small decrease in volume only leads to a relatively small increase in pressure as compared to a liquid.

The ratio of the volume of the dielectric liquid and the volume of the gas or the gas mixture comprised in the enclosure may for example be at least 2:1, preferably at least 3:1. As an example, only 10% or less of the volume of the enclosure available for filling may be gas filled, whereas the rest of the volume may be filled with the dielectric liquid. An efficient cooling of the electronic component even in different orientations of the enclosure can thus be ensured.
The gas or gas mixture may for example comprise nitrogen (N₂).
The predetermined pressure which the enclosure is adapted to maintain is smaller than 10 bar, preferably smaller than 2 bar, and more preferably in a range between about 0.9 and about 1.5 bar. As an example, the enclosure may be adapted to maintain a pressure of approximately 1 bar, e.g. one atmosphere (1.013 bar). This has the advantage that most electronic components can be operated in such a subsea electronic system.

The enclosure is adapted to maintain the predetermined pressure inside up to a deployment depth of water of at least 1000m, preferably at least 2000m. With such a configuration, the subsea electronic system can be deployed at most offshore drilling sites.
The dielectric liquid and the gas or gas mixture may be separated by a flexible element. A sloshing around of the dielectric liquid inside the enclosure may thus be prevented. Furthermore, it can be ensure that the electronic component is submerged in the dielectric liquid. A flexible element may for example be a bellow, a diaphragm, a membrane or a bladder. It is certainly also conceivable to provide the dielectric liquid and the gas or gas mixture in different chambers separated by such a flexible element. According to the invention, the enclosure and the heat generating electronic component are arranged and configured such that in operation of the subsea electronic system, a convection current supporting the transportation of heat generated by the electronic component to the at least one wall of the enclosure is established in the dielectric liquid. The electronic component may for example be spaced and oriented relative to the wall of the enclosure in such a way that the convectional current can be established. It is thus possible to dissipate a larger amount of heat generated by the electronic component.
The system may also comprise flow guiding elements which may promote the generation of such convection current or which may direct the convection current.
Establishing the convection current further has the advantage that no additional mechanical or electrical components for generating a flow in the liquid need to be provided, thus simplifying the design of the system. Yet the provisioning of such components is certainly conceivable. In an embodiment, the system may for example comprise a flow generating element disposed in the enclosure and adapted to actively generate a flow in the dielectric liquid for supporting the transportation of heat generated by the electronic component to the at least one wall of the enclosure. The flow generating element may for example be a pumping mechanism, which may comprise a rotor, such as a propeller, an impeller or their like. By actively driving the flow of the dielectric liquid, even higher heat dissipation can be achieved. According to the invention, the subsea electronic system comprises a heat sink mounted to an inner side of the wall of the enclosure and arranged such that when the subsea electronic system is deployed under water in a operating state, the heat sink is at least partially submerged in the dielectric liquid. The fins of the heat sink are aligned in a way so that the fluid flow of the convection current is parallel to the elongation of the fins. A heat sink is generally a thermal conductor and may also be called a heat dissipater. It generally provides an enlarged surface which is in contact with the surrounding medium, here the dielectric liquid, so as to improve the heat exchange between the liquid and the wall of the enclosure towards which the heat sink is coupled.

The subsea electronic system may further comprise a flow guiding member adapted to guide a flow of the dielectric liquid towards the heat sink. Such a flow may for example be the above mentioned convection current or the actively generated flow of the dielectric liquid. By guiding the flow towards the heat sink, the heat exchange and thus the heat dissipation from the electronic component can be further improved.

The subsea electronic system may comprise a heat sink mounted to an outer side of the wall of the enclosure and arranged so as to be in contact with surrounding water when the subsea electronic system is deployed under water. By means of such a heat sink, heat taken up by the wall of the enclosure can be dissipated effectively into the surrounding seawater.

The heat sink mounted to the inner side or outer side of the wall of the enclosure may be thermally coupled to the wall and may be configured to increase the contact area of the wall with the dielectric liquid or water, respectively, so as to increase the heat exchange between the dielectric liquid or water and the wall. Due to the thermal coupling, a good heat exchange between the heat sink and the wall is ensured, and the heat sink may in this respect be regarded as forming part of the wall. A larger contact area means that the liquid can be cooled more effectively by the wall of the enclosure, which on its other side is in contact with the seawater.

The dielectric liquid may be oil, such as transformer oil or silicon oil. Such types of dielectric liquid have good electrical insulating properties and remain stable even at high temperatures. Electrical breakdowns, which may occur due to electric sparking or arcing, may thus be prevented. A liquid dielectric further recovers its dielectric performance after sparking.

Another aspect of the invention provides a method of cooling a heat generating electronic component of a subsea electronic system, the electronic component being arranged in a pressure resistant enclosure of a subsea electronic system which is adapted to maintain a predetermined pressure inside the enclosure when the system is deployed under water. The method comprises providing a dielectric liquid in the enclosure and configuring the subsea electronic system such that when the subsea electronic system is deployed under water in an operating state, the electronic component is at least partially submerged in the dielectric liquid and the dielectric liquid is in contact with at least one wall of the enclosure. In operation, the heat generating electronic component is cooled by transferring heat generated by the electronic component to the at least one wall of the enclosure via are the dielectric liquid.

With the inventive method, advantages similar to those outlined further about may be achieved.

In an embodiment, the method may further comprise the step of configuring the subsea electronic system according to any of the above mentioned embodiments.

The features of the embodiments mentioned above and those yet to be explained below can be combined with each other unless noted to the contrary.

### Brief description of the drawings

The forgoing and other features and advantages of the invention will become further a parent from the following detailed description read in conjunction with the accompanying drawings. In the drawings, like reference numerals refer to like elements.
Figure 1 shows a schematic drawing of a subsea electronic system according to an embodiment.
Figure 2 schematically illustrates a heat sink mounted to the enclosure of a subsea electronic system according to an embodiment of the invention.
Figure 3 shows a schematic drawing of a subsea electronic system according to an embodiment of the invention making use of a heat sink.
Figure 4 is a schematic drawing of a subsea electronic system according to another embodiment of the invention.

In the following, embodiments of the present invention will be described in detail with reference to the accompanying drawings. It is to be understood that the following description of the embodiments is given only for the purpose of illustration and is not to be taken in a limiting sense.

It should be noted that the drawings are to be regarded as being schematic representations only, and elements in the drawings are not necessary to scale with each other. Rather, the representation of the various elements is chosen such that their function in general purpose becomes apparent to a person skilled in the art.

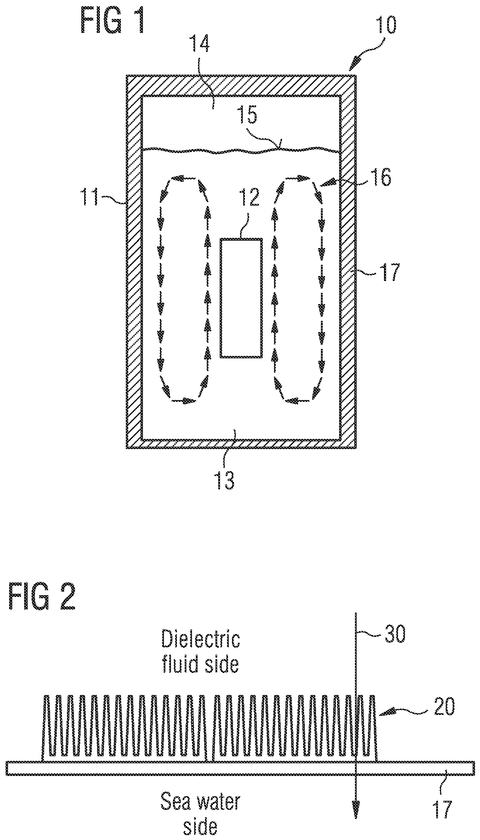

Figure 1 illustrates a subsea electronic system 10 which comprises a pressure resistant enclosure 11 in which a heat generating electronic component 12 is disposed. The enclosure 11 is water tight, so that when the system 10 is deployed under water, no seawater can enter the enclosure.

Furthermore, the walls of the enclosure 11 are strong enough so that a predefined pressure can be maintained inside the enclosure when it is submerged under water. Enclosure 11 does protect the electronic component 12 from the outside pressure which dramatically increases when the subsea electronic system 10 is deployed under water for example in proximity to a wellhead assembly of an offshore oil or gas well.

The size of the enclosure can be adapted to the size of the electronic component it is supposed to house. The enclosure may have a volume of more than 1000 cm³, or for larger components of more than 10000 cm³ or even more than 100000 cm³.

Enclosure 11 can be configured to maintain an inside pressure of approximately one atmosphere. It should be clear that the pressure inside the enclosure 11 may also be set to other predefined values, which may for example be determined by the deployment depth and which may decrease the differential pressure (the pressure difference between outside and inside the enclosure). Enclosure 11 can be configured to maintain the above mentioned inside pressure up to a deployment depth of at least 1000m, preferably at least 2000m. The subsea electronic system 10 can thus be deployed at offshore oil wells located such depths.

The enclosure 11 is at least partially filled with a dielectric liquid 13. Dielectric liquid 13 may be oil, such as transformer oil or silicon oil, and is provided for cooling the electronic component 12.

Enclosure 11 may be completely filled with dielectric liquid 13. For facilitating the maintaining of the predefined pressure inside the enclosure, it is advantages to only partially fill the enclosure 11 with the dielectric liquid, and to fill the remaining volume of the enclosure with a gas or gas mixture 14, as illustrated in Fig. 1. Nitrogen or air may for example be used as a gas or gas mixture 14. When the subsea electronic system 10 is deployed under water, a slight deformation of the enclosure 11 may occur due to the high pressures. By providing a small volume of gas inside the enclosure, a small change of the volume of the enclosure only results in a corresponding small change of the pressure inside the enclosure, due to the compressibility of the gas or gas mixture 14. The predefined pressure can thus be maintained inside the enclosure 11 even if the system 10 is deployed at large depths.

As illustrated in Fig. 1, the volume fraction taken up by the gas or gas mixture of the space inside the enclosure 11 does not to be need large; it may for example be smaller than one half or one third of the volume taken up by the dielectric liquid 13. The volume fraction may be adapted in accordance with the requirements on cooling and on pressure maintenance.

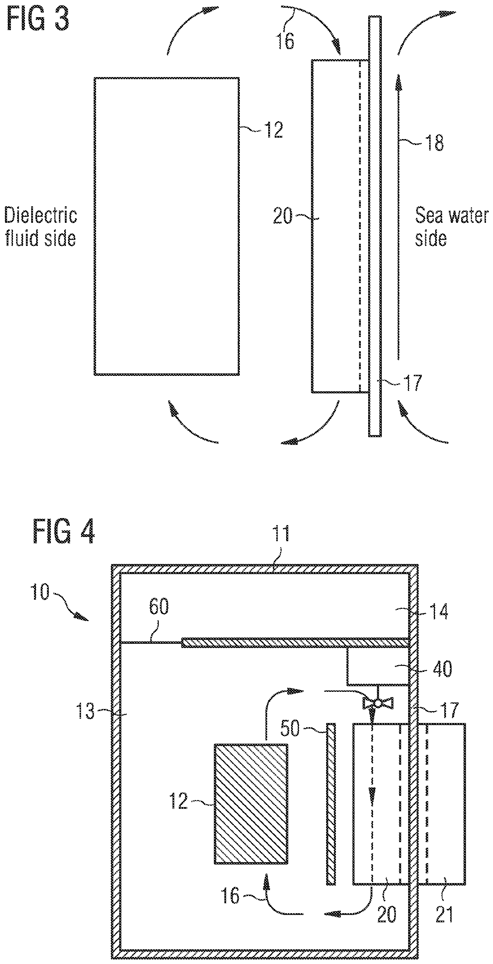

Reference symbol 15 illustrates the level of the dielectric liquid 13 in the enclosure 11. Although in the example of figure 1, the gas or gas mixture 14 is in direct contact with the dielectric liquid 13, it should be clear that in other configurations, they may be provided in separate chambers and may be separated from each other, as for example illustrated in the embodiment of figure 4, which is explained in more detail further below.

The electronic component 12 may comprise one or more electronic elements, which can for example be provided on a printed or another type of circuit board. The electronic component may for example comprise circuit elements, integrated circuits, chips, resistors, capacitors and the like. Some of these components can not be pressurized, i.e. they need to be maintained at a close to atmospheric pressure level. Examples include electrolytic capacitors, which may comprise pockets of air. When pressurized, such capacitors may get crushed by the pressure increase. By maintaining the pressure inside the enclosure 11 at approximately one atmosphere, most conventional electric elements can be used in the electronic component 12.

Due to heat losses in the electronic elements, the electronic component 12 generates heat in operation. The electronic component 12 is at least partially submerged in the dielectric liquid 13, i.e. it is in direct contact with the liquid, thereby ensuring a good transfer of heat from the electronic component to the dielectric liquid. In particular, the electronic component 12 can be submerged in the liquid 13 in such a way that all the electronic elements that produce excess heat and require cooling are submerged in the liquid. In the example of figure 1, the electronic component 12 is completely submerged, so that all electronic elements thereon are cooled. The direct contact between the dielectric liquid and the electronic elements provides a good thermal conductivity and thus an efficient cooling. As the dielectric liquid is insulating, the functionality of the electronic component 12 is not compromised by submerging it in the liquid. If an electronic element is incompatible with an operation in dielectric liquid, it may be provided with a special housing, for example by molding. Even for such types of elements, a good heat transfer can thus be ensured.

At one atmosphere, the dielectric liquid 13 generally has a much higher thermal conductivity and heat capacity than a gas or gas mixture. Heat produce by electrical component 12 is thus efficiently taken up and transported by the dielectric liquid 13. The dielectric liquid 13 transfers the heat which it has taken up to the walls of the container 11 which it contacts, for example the wall 17. Heat transfer can occur by thermal conduction of the generated heat via the dielectric liquid to the walls of the enclosure 11, and it can be supported by convection. In particular, the subsea electronic system can be configured in such a way that a convection current (also called advection) forms in the dielectric liquid 13. Such convection currents can form naturally due to the differences in density of heated and cooled dielectric liquid. Liquid warmed up by the electronic component 12 is generally less dense and will thus rise, leading to the formation of the convection current.

In the example of Fig.1, the electronic component 12 is positioned close to the center of the enclosure 11 and at a predefined distance to wall 17. Dielectric liquid in contact with the electronic component 12 takes up heat generated by the component and rises, whereas dielectric liquid in contact with the wall 17 is cooled and drops. The spacing between wall 17 and electronic component 12 is chosen large enough so that the above processes generate the fluid flow 16 (convection current). Other configurations for generating a convectional fluid flow or arrangements of component 12 relative to the enclosure 11 are certainly conceivable.

The warmed up dielectric liquid transports the absorbed heat to wall 17, which takes up the heat and transfers it to the outside of the enclosure 11. The outer side of wall 17 is in contact with the surrounding sea water, to which the heat is transferred. The overall process does achieve effective heat dissipation.

By means of the thermal conduction and convection, the dielectric liquid 13 very effectively removes heat from the electronic component 12. The subsea electronic system 10 thereby provides an effective cooling of the electronic component 12 and ensures that the operating temperature of the electronic component maintains an acceptable level even for high heat losses. Electronic component 12 can thus be operated at low temperatures, which generally increases the reliability of such components. Operation at higher temperatures further often decreases the lifetime of electronic components, so that by providing the above mentioned effective cooling, the lifetime can be increased and maintenance requirements can be reduced.

It should be clear that the subsea electronic systems 10 may comprise further components that are not illustrated in figure 1, such as the components illustrated with respect to the subsequent figures 2 to 4. Other components may for example comprise a mount or a support structure by means of which the electronic component 12 is supported on a wall of the enclosure 11, or other elements commonly used in such systems. Enclosure 11 may for example be a subsea canister or there like. It should further be clear that the electronic component 12 does not need to comprise a circuit board, chips, integrated circuits or any of above mentioned electronic elements, but may comprise very simple electronics requiring cooling, such a power electronics which may comprise a rectifier, a thyristor or the like.

For improving the heat transfer from the dielectric liquid 13 to the surrounding sea water, a heat sink 20 may be provided on one or more walls of the enclosure 11, as illustrated in figure 2. Arrow 30 illustrates the direction of the heat flow from the dielectric fluid side to the sea water side across wall 17 of the enclosure 11. In the example of figure 2, the heat sink 20 comprises a base plate from which fins extend into the dielectric fluid. Besides this straight fin type heat sink, other types of heat sinks, such as pin or flare fin heat sinks may certainly also be used. Heat sink 20 is thermally coupled to wall 17. This may be achieved by using the appropriate coupling means, such as a heat conductive paste or they like, by tightly mounting the heat sink to the wall 17 in a way that maximizes the contact surface or by integrally forming the heat sink 20 with the wall 17. The heat sink may be formed of aluminum or any other suitable material. Due to its structure, the heat sink provides a large contact surface with the dielectric fluid, and thus effectively increases the contact surface of the dielectric fluid with the wall 17.

In particular, the heat sink is adapted and arranged on wall 17 in such a way that the thermal resistance through the material of the heat sink is kept as low as possible. In configurations where a split exists between the heat sink and the wall, the split may be filled with the dielectric liquid or another material having a high thermal conductivity, such as a heat conductive paste in order to improve the heat transfer.

As illustrated in figure 3, the heat sink may be mounted to an inner side of wall 17 of the subsea electronic system 10 of figure 1. The fins of the heat sink may be aligned in a way so that the fluid flow of the convection current is parallel to the elongation of the fins. This why, the fins of the heat sink apply the minimum possible flow resistance to the convection current. In Fig. 3, the reference symbol 18 illustrates a flow of seawater along the outer side of wall 17 of the enclosure 11.

By making use of heat sink 20, the thermal conductivity between the internal dielectric fluid and the external water is enhanced. For further improving the conductivity, it is certainly considerable to place another heat sink on the outer side of wall 17, i.e. the seawater side.

Such a configuration is illustrated in Fig. 4. Wall 17 of the subsea electronic system 10 is now provided with an inner heat sink 20 and an outer heat sink 21.

It is also possible to provide the subsea electronic system 10 with a flow generating element as illustrated in figure 4. The flow generating element 40 is provided in form of a propeller which generates a flow in the dielectric liquid when rotated. In the example of figure 4, the flow generating element is positioned such that the generated flow is forced through the heat sink 20. This enhances the efficiency of the heat sink and improves the heat exchange. Flow generating element 40 may also be provided in other positions, for example so has to generate a flow past the electronic component 12. The flow generating element 40 can also be provided in systems which do not comprise a heat sink.

Other implementations include an impeller, different types of pumps or any other configuration conceivable for generating a flow in the dielectric liquid.

Subsea electronic system 10 comprises a flow guiding member 50 in the example of figure 4. It ensures that the flow of dielectric fluid passes along the heat sink 20 and does not leave the heat sink prematurely. It is further used to guide the flow towards the heat sink. In other implementations, the flow guiding member can be used without a heat sink, i.e. for guiding a flow of liquid towards the wall of the enclosure or towards the electronic component, or it can be used without the flow generating element 40, for directing the convection flow into the desired direction.

The flow guiding member 50 is used to control the flow in the dielectric liquid. It can for example be implemented as one or more plates, which can be made out of steel, plastic or other suitable materials. The flow guiding member may for example be placed on the top of heat sink 20 in order to gather the heated dielectric fluid and feed it through the heat sink. This is possible both for configurations having an actively driven fluid flow and for configurations using only the convection current.

Figure 4 further illustrates the possibility of separating the dielectric liquid 13 and the gas or gas mixture 14 by a flexible element 60, which is a diaphragm or membrane in the illustrated example. The liquid 13 and the gas 14 are each provided in a chamber, the two chambers being separated by the flexible element 60. Thus, the pressure is balanced between the two chambers, and a slashing around of the dielectric liquid can be prevented. In other configurations, a bellow or a bladder may be used as a flexible element for pressure balancing.

The skilled person will appreciate that figures 2 to 4 show several modifications of the subsea electronic system 10 of figure 1. Consequently, the explanations given with respect to figure 1 are equally applicable to the configurations shown in figures 2 to 4. The skilled person will further appreciate that the features explained above with respect to the figures can be combined in other combinations as the ones illustrated. The configuration can be adapted to the particular cooling requirements. The subsea electronic system of the present invention can be deployed at large water depths while still maintaining a predefined pressure inside and effectively cooling the electronic component. Heat losses of subsea electronics can thus be controlled.

## Claims

1. A subsea electronic system (10), comprising:
- a pressure resistant enclosure (11) adapted to maintain a predetermined pressure inside the enclosure (11) when the system (10) is deployed under water, wherein the predetermined pressure which the enclosure (11) is adapted to maintain is smaller than 10 bar, preferably smaller than 2 bar, wherein the enclosure (11) is adapted to maintain the predetermined pressure up to a deployment depth of water of at least 1000 m;
- a heat generating electronic component (12) arranged in the enclosure (11), the electronic component (12) generating heat in operation;
- a dielectric liquid (13) which at least partially fills said enclosure (11),
wherein the subsea electronic system (10) is configured such that when the subsea electronic system (10) is deployed under water in an operating state, the electronic component (12) is at least partially submerged in the dielectric liquid (13) and the dielectric liquid (13) is in contact with at least one wall (17) of the enclosure (11) so as to enable a transfer of heat from the heat generating electronic component (12) to the at least one wall (17) of the enclosure (11) via the dielectric liquid (13) so that on the other side of the at least one wall (17), the heat is taken up by surrounding seawater,
wherein the enclosure (11) and the heat generating electronic component (12) are arranged and configured such that in operation of the system (10), a convection current (16) is established in said dielectric liquid (13) for supporting the transportation of heat generated by the electronic component (12) to the at least one wall (17) of the enclosure (11),
the subsea electronic system (10) further comprising a heat sink (20) mounted to an inner side of the wall (17) of the enclosure (11) and arranged such that when the subsea electronic system (10) is deployed under water in an operating state, the heat sink (20) is at least partially submerged in the dielectric liquid (13),
wherein fins of the heat sink (20) are aligned in a way so that the fluid flow of the convection current (16) is parallel to the elongation of the fins.

2. The subsea electronic system according to claim 1, wherein the enclosure (11) is further partially filled with a gas or a gas mixture (14).

3. The subsea electronic system according to claim 2, wherein the ratio of the volume of the dielectric liquid (13) and the volume of the gas or gas mixture (14) comprised in the enclosure (11) is at least 2:1, preferably at least 3:1.

4. The subsea electronic system according to claim 2 or 3,
wherein the gas or gas mixture (14) comprises nitrogen.

5. The subsea electronic system according to any of the preceding claims, wherein the predetermined pressure which the enclosure (11) is adapted to maintain is in a range between about 0.9 and about 1.5 bar.

6. The subsea electronic system according to any of the preceding claims, wherein the enclosure (11) is adapted to maintain the predetermined pressure up to a deployment depth of water of at least 2000 m.

7. The subsea electronic system according to any of the preceding claims and claim 2, wherein the dielectric liquid (13) and the gas or gas mixture (14) are separated by a flexible element (60), such as a bellow, a diaphragm, a membrane or a bladder.

8. The subsea electronic system according to any of the preceding claims, wherein the system further comprises a flow generating element (40) disposed in the enclosure (11) and adapted to actively generate a flow in the dielectric liquid (13) for supporting the transportation of heat generated by the electronic component (12) to the at least one wall (17) of the enclosure (11).

9. The subsea electronic system according to any of the preceding claims, further comprising a flow guiding member (50) adapted to guide a flow of the dielectric liquid (13) towards the heat sink (20).

10. The subsea electronic system according to any of the preceding claims, further comprising a heat sink (21) mounted to an outer side of the wall (17) of the enclosure (11) and arranged so as to be in contact with surrounding water when the subsea electronic system (10) is deployed under water.

11. The subsea electronic system according to any of the preceding claims, wherein the heat sink (20, 21) mounted to the inner side or outer side of the wall of the enclosure (11) is thermally coupled to the wall (17) and is configured to increase the contact area of the wall with the dielectric liquid or water, respectively, so as to increase the heat exchange between the dielectric liquid or water and the wall.

12. A method of cooling a heat generating electronic component (12) of a subsea electronic system (10), the electronic component (12) being arranged in a pressure resistant enclosure (11) of the subsea electronic system (10) which is adapted to maintain a predetermined pressure inside the enclosure (11) when the system (10) is deployed under water, wherein the predetermined pressure which the enclosure (11) is adapted to maintain is smaller than 10 bar, preferably smaller than 2 bar, wherein the enclosure (11) is adapted to maintain the predetermined pressure up to a deployment depth of water of at least 1000 m, the method comprising the steps of:
- providing a dielectric liquid (13) in the enclosure (11),
- configuring the subsea electronic system (10) such that when the subsea electronic system is deployed under water in an operating state, the electronic component (12) is at least partially submerged in the dielectric liquid (13) and the dielectric liquid (13) is in contact with at least one wall (17) of the enclosure (11), so that in operation, the heat generating electronic component (12) is cooled by transferring heat generated by the heat generating electronic component (12) to the at least one wall (17) of the enclosure (11) via the dielectric liquid (13) so that on the other side of the at least one wall (17), the heat is taken up by surrounding seawater,
wherein the enclosure (11) and the heat generating electronic component (12) are arranged and configured such that in operation of the system (10), a convection current (16) is established in said dielectric liquid (13) for supporting the transportation of heat generated by the electronic component (12) to the at least one wall (17) of the enclosure (11),
the subsea electronic system (10) further comprising a heat sink (20) mounted to an inner side of the wall (17) of the enclosure (11) and arranged such that when the subsea electronic system (10) is deployed under water in an operating state, the heat sink (20) is at least partially submerged in the dielectric liquid (13),
wherein the fins of the heat sink (20) are aligned in a way so that the fluid flow of the convection current (16) is parallel to the elongation of the fins.

13. The method according to claim 12, further comprising the step of configuring the subsea electronic system (10) according to one of claims 2-11.

## Patentansprüche

1. Unterwasserelektroniksystem (10), welches Folgendes umfasst:
- eine druckfeste Einhausung (11), welche dazu ausgebildet ist, einen vorgegebenen Druck innerhalb der Einhausung (11) aufrechtzuerhalten, wenn das System (10) unter Wasser eingesetzt wird, wobei der vorgegebene Druck, für dessen Aufrechterhaltung die Einhausung (11) ausgebildet ist, kleiner als 10 bar, vorzugsweise kleiner als 2 bar ist, wobei die Einhausung (11) dazu ausgebildet ist, den vorgegebenen Druck bis zu einer Einsatzwassertiefe von mindestens 1.000 m aufrechtzuerhalten;
- eine in der Einhausung (11) angeordnete wärmeerzeugende Elektronikkomponente (12), wobei die Elektronikkomponente (12) im Betrieb Wärme erzeugt;
- ein dielektrisches Fluid (13), welches die Einhausung (11) zumindest teilweise füllt,
wobei das Unterwasserelektroniksystem (10) derart ausgestaltet ist, dass wenn das Unterwasserelektroniksystem (10) unter Wasser in einem Betriebszustand eingesetzt wird, die Elektronikkomponente (12) mindestens teilweise in das dielektrische Fluid (13) eintaucht und das dielektrische Fluid (13) mit mindestens einer Wand (17) der Einhausung (11) in Kontakt steht, um so einen Transfer von Wärme von der wärmeerzeugenden Elektronikkomponente (12) zu der mindestens einen Wand (17) der Einhausung (11) über das dielektrische Fluid (13) zu ermöglichen, sodass auf der anderen Seite der mindestens einen Wand (17) die Wärme durch das umgebende Seewasser aufgenommen wird,
wobei die Einhausung (11) und die wärmeerzeugende Elektronikkomponente (12) derart angeordnet und ausgestaltet sind, dass im Betrieb des Systems (10) in dem dielektrischen Fluid (13) ein Konvektionsstrom (16) aufgebaut wird zum Unterstützen des Transports von durch die Elektronikkomponente (12) erzeugter Wärme zu der mindestens einen Wand (17) der Einhausung (11), wobei das Unterwasserelektroniksystem (10) ferner einen an einer Innenseite der Wand (17) der Einhausung (11) angebrachten und so angeordneten Kühlkörper (20) umfasst, dass wenn das Unterwasserelektroniksystem (10) unter Wasser in einem Betriebszustand eingesetzt wird, der Kühlkörper (20) mindestens teilweise in das dielektrische Fluid (13) eintaucht, wobei die Rippen des Kühlkörpers (20) so ausgerichtet sind, dass die Fluidströmung des Konvektionsstroms (16) parallel zur Verlängerung der Rippen ist.

2. Unterwasserelektroniksystem nach Anspruch 1, wobei die Einhausung (11) ferner teilweise mit einem Gas oder einem Gasgemisch (14) gefüllt ist.

3. Unterwasserelektroniksystem nach Anspruch 2, wobei das Verhältnis des Volumens des dielektrischen Fluids (13) und des Volumen des in der Einhausung (11) enthaltenen Gases oder Gasgemischs (14) mindestens 2:1, vorzugsweise 3:1 ist.

4. Unterwasserelektroniksystem nach Anspruch 2 oder 3, wobei das Gas oder Gasgemisch (14) Stickstoff enthält.

5. Unterwasserelektroniksystem nach einem der vorhergehenden Ansprüche, wobei der vorgegebene Druck, zu dessen Aufrechterhaltung die Einhausung (11) ausgebildet ist, in einem Bereich zwischen etwa 0,9 und etwa 1,5 bar liegt.

6. Unterwasserelektroniksystem nach einem der vorhergehenden Ansprüche, wobei die Einhausung (11) dazu ausgebildet ist, den vorgegebenen Druck bis zu einer Einsatzwassertiefe von mindestens 2.000 m aufrechtzuerhalten.

7. Unterwasserelektroniksystem nach einem der vorhergehenden Ansprüche und Anspruch 2, wobei das dielektrische Fluid (13) und das Gas oder Gasgemisch (14) durch ein flexibles Element (60) wie einen Balg, ein Diaphragma, eine Membran oder eine Blase getrennt sind.

8. Unterwasserelektroniksystem nach einem der vorhergehenden Ansprüche, wobei das System ferner ein strömungserzeugendes Bauteil (40) umfasst, welches in der Einhausung (11) angeordnet und ausgebildet ist zum Erzeugen einer Strömung in dem dielektrischen Fluid (13) zum Unterstützen des Transports von durch die Elektronikkomponente (12) erzeugter Wärme zu der mindestens einen Wand (17) der Einhausung (11).

9. Unterwasserelektroniksystem nach einem der vorhergehenden Ansprüche, ferner umfassend ein störmungsführendes Bauteil (50), welches dazu ausgebildet ist, einen Strom des dielektrischen Fluids (13) zu dem Kühlkörper (20) zu führen.

10. Unterwasserelektroniksystem nach einem der vorhergehenden Ansprüche, ferner umfassend einen an einer Außenseite der Wand (17) der Einhausung (11) angebrachten und derart angeordneten Kühlkörper (21), dass er in Kontakt mit dem umgebenden Wasser steht, wenn das Unterwasserelektroniksystem (10) unter Wasser eingesetzt wird.

11. Unterwasserelektroniksystem nach einem der vorhergehenden Ansprüche, wobei der an der Innenseite oder Außenseite der Wand der Einhausung (11) angebrachte Kühlkörper (20, 21) thermisch mit der Wand (17) gekoppelt und dazu ausgebildet ist, die Kontaktfläche der Wand mit dem dielektrischen Fluid bzw. Wasser zu vergrößern, um den Wärmeaustausch zwischen dem dielektrischen Fluid oder Wasser und der Wand zu erhöhen.

12. Verfahren zum Kühlen einer wärmeerzeugenden Elektronikkomponente (12) eines Unterwasserelektroniksystems (10), wobei die Elektronikkomponente (12) in einer druckfesten Einhausung (11) des Unterwasserelektroniksystems (10) angeordnet ist, welches dazu ausgebildet ist, einen vorgegebenen Druck innerhalb der Einhausung (11) aufrechtzuerhalten, wenn das System (10) unter Wasser eingesetzt wird, wobei der vorgegebene Druck, für dessen Aufrechterhaltung die Einhausung (11) ausgebildet ist, kleiner als 10 bar, vorzugsweise kleiner als 2 bar ist, wobei die Einhausung (11) dazu ausgebildet ist, den vorgegebenen Druck bis zu einer Einsatzwassertiefe von mindestens 1.000 m aufrechtzuerhalten, wobei das Verfahren die Schritte umfasst:
- Bereitstellen eines dielektrischen Fluids (13) in der Einhausung (11),
- Ausgestalten des Unterwasserelektroniksystems (10) derart, dass wenn das Unterwasserelektroniksystem unter Wasser in einem Betriebszustand eingesetzt wird, die Elektronikkomponente (12) mindestens teilweise in das dielektrische Fluid (13) eintaucht und das dielektrische Fluid (13) mit mindestens einer Wand (17) der Einhausung (11) in Kontakt steht, um so einen Transfer von Wärme von der wärmeerzeugenden Elektronikkomponente (12) zu der mindestens einen Wand (17) der Einhausung (11) über das dielektrische Fluid (13) zu ermöglichen, sodass auf der anderen Seite der mindestens einen Wand (17) die Wärme durch das umgebende Seewasser aufgenommen wird,
wobei die Einhausung (11) und die wärmeerzeugende Elektronikkomponente (12) derart angeordnet und ausgestaltet sind, dass im Betrieb des Systems (10) in dem dielektrischen Fluid (13) ein Konvektionsstrom (16) aufgebaut wird zum Unterstützen des Transports von durch die Elektronikkomponente (12) erzeugter Wärme zu der mindestens einen Wand (17) der Einhausung (11), wobei das Unterwasserelektroniksystem (10) ferner einen an einer Innenseite der Wand (17) der Einhausung (11) angebrachten und so angeordneten Kühlkörper (20) umfasst, dass wenn das Unterwasserelektroniksystem (10) unter Wasser in einem Betriebszustand eingesetzt wird, der Kühlkörper (20) mindestens teilweise in das dielektrische Fluid (13) eintaucht, wobei die Rippen des Kühlkörpers (20) so ausgerichtet sind, dass die Fluidströmung des Konvektionsstroms (16) parallel zur Verlängerung der Rippen ist.

13. Verfahren nach Anspruch 12, ferner umfassend den Schritt des Ausgestaltens des Unterwasserelektroniksystems (10) nach einem der Ansprüche 2 bis 11.

## Revendications

1. Un système électronique sous-marin (10), comprenant :
- une enceinte résistant à la pression (11) adaptée de façon à maintenir une pression prédéterminée à l'intérieur de l'enceinte (11) lorsque le système (10) est déployé sous l'eau, la pression prédéterminée que l'enceinte (11) est adaptée de façon à maintenir étant inférieure à 10 bars, de préférence inférieure à 2 bars, l'enceinte (11) étant adaptée de façon à maintenir la pression prédéterminée jusqu'à une profondeur d'eau de déploiement d'au moins 1000 m,
- un composant électronique de génération de chaleur (12) agencé dans l'enceinte (11), le composant électronique (12) générant de la chaleur en fonctionnement,
- un liquide diélectrique (13) qui remplit au moins partiellement ladite enceinte (11),
dans lequel le système électronique sous-marin (10) est configuré de sorte que, lorsque le système électronique sous-marin (10) est déployé sous l'eau dans un état opérationnel, le composant électronique (12) est au moins partiellement immergé dans le liquide diélectrique (13) et le liquide diélectrique (13) est en contact avec au moins une paroi (17) de l'enceinte (11) de façon à permettre un transfert de chaleur du composant électronique de génération de chaleur (12) vers la au moins une paroi (17) de l'enceinte (11) par l'intermédiaire du liquide diélectrique (13) de sorte que, de l'autre côté de la au moins une paroi (17), la chaleur soit absorbée par l'eau de mer environnante,
dans lequel l'enceinte (11) et le composant électronique de génération de chaleur (12) sont agencés et configurés de sorte que, en fonctionnement du système (10), un courant de convection (16) soit établi dans ledit liquide diélectrique (13) de façon à prendre en charge le transport de chaleur générée par le composant électronique (12) vers la au moins une paroi (17) de l'enceinte (11),
le système électronique sous-marin (10) comprenant en outre un dissipateur thermique (20) monté sur un côté intérieur de la paroi (17) de l'enceinte (11) et agencé de sorte que, lorsque le système électronique sous-marin (10) est déployé sous l'eau dans un état opérationnel, le dissipateur thermique (20) est au moins partiellement immergé dans le liquide diélectrique (13),
dans lequel des ailettes du dissipateur thermique (20) sont alignées de telle manière que l'écoulement de fluide du courant de convection (16) est parallèle à l'élongation des ailettes.

2. Le système électronique sous-marin selon la revendication 1, dans lequel l'enceinte (11) est en outre partiellement remplie avec un gaz ou un mélange gazeux (14).

3. Le système électronique sous-marin selon la revendication 2, dans lequel le rapport du volume du liquide diélectrique (13) sur le volume du gaz ou du mélange gazeux (14) contenu dans l'enceinte (11) est d'au moins 2:1, de préférence d'au moins 3:1.

4. Le système électronique sous-marin selon la revendication 2 ou 3, dans lequel le gaz ou le mélange gazeux (14) contient de l'azote.

5. Le système électronique sous-marin selon l'une quelconque des revendications précédentes, dans lequel la pression prédéterminée que l'enceinte (11) est adaptée de façon à maintenir se situe dans une plage entre environ 0,9 et environ 1,5 bar.

6. Le système électronique sous-marin selon l'une quelconque des revendications précédentes, dans lequel l'enceinte (11) est adaptée de façon à maintenir la pression prédéterminée jusqu'à une profondeur d'eau de déploiement d'au moins 2000 m.

7. Le système électronique sous-marin selon l'une quelconque des revendications précédentes et la revendication 2, dans lequel le liquide diélectrique (13) et le gaz ou le mélange gazeux (14) sont séparés par un élément souple (60), tel qu'un soufflet, un diaphragme, une membrane ou une poche.

8. Le système électronique sous-marin selon l'une quelconque des revendications précédentes, dans lequel le système comprend en outre un élément de génération de flux (40) disposé dans l'enceinte (11) et adapté de façon à générer de manière active un écoulement dans le liquide diélectrique (13) de façon à prendre en charge le transport de chaleur générée par le composant électronique (12) vers la au moins une paroi (17) de l'enceinte (11).

9. Le système électronique sous-marin selon l'une quelconque des revendications précédentes, comprenant en outre un élément de guidage d'écoulement (50) adapté de façon à guider un écoulement du liquide diélectrique (13) vers le dissipateur thermique (20).

10. Le système électronique sous-marin selon l'une quelconque des revendications précédentes, comprenant en outre un dissipateur thermique (21) monté sur un côté extérieur de la paroi (17) de l'enceinte (11) et agencé de façon à être en contact avec l'eau environnante lorsque le système électronique sous-marin (10) est déployé sous l'eau.

11. Le système électronique sous-marin selon l'une quelconque des revendications précédentes, dans lequel le dissipateur thermique (20, 21) monté sur le côté intérieur ou le côté extérieur de la paroi de l'enceinte (11) est couplé thermiquement à la paroi (17) et est configuré de façon à augmenter la zone de contact de la paroi avec le liquide diélectrique ou l'eau respectivement, de façon à augmenter l'échange thermique entre le liquide diélectrique ou l'eau et la paroi.

12. Un procédé de refroidissement d'un composant électronique de génération de chaleur (12) d'un système électronique sous-marin (10), le composant électronique (12) étant agencé dans une enceinte résistant à la pression (11) du système électronique sous-marin (10) qui est adaptée de façon à maintenir une pression prédéterminée à l'intérieur de l'enceinte (11) lorsque le système (10) est déployé sous l'eau, la pression prédéterminée que l'enceinte (11) est adaptée de façon à maintenir étant inférieure à 10 bars, de préférence inférieure à 2 bars, l'enceinte (11) étant adaptée de façon à maintenir la pression prédéterminée jusqu'à une profondeur d'eau de déploiement d'au moins 1000 m, le procédé comprenant les étapes suivantes :
- la fourniture d'un liquide diélectrique (13) dans l'enceinte (11),
- la configuration du système électronique sous-marin (10) de sorte que, lorsque le système électronique sous-marin est déployé sous l'eau dans un état opérationnel, le composant électronique (12) est au moins partiellement immergé dans le liquide diélectrique (13) et le liquide diélectrique (13) est en contact avec au moins une paroi (17) de l'enceinte (11), de sorte que, en fonctionnement, le composant électronique de génération de chaleur (12) soit refroidi par le transfert de la chaleur générée par le composant électronique de génération de chaleur (12) vers la au moins une paroi (17) de l'enceinte (11) par l'intermédiaire du liquide diélectrique (13) de sorte que, de l'autre côté de la au moins une paroi (17), la chaleur soit absorbée par l'eau de mer environnante,
dans lequel l'enceinte (11) et le composant électronique de génération de chaleur (12) sont agencés et configurés de sorte que, en fonctionnement du système (10), un courant de convection (16) soit établi dans ledit liquide diélectrique (13) de façon à prendre en charge le transport de la chaleur générée par le composant électronique (12) vers la au moins une paroi (17) de l'enceinte (11), le système électronique sous-marin (10) comprenant en outre un dissipateur thermique (20) monté sur un côté intérieur de la paroi (17) de l'enceinte (11) et agencé de sorte que, lorsque le système électronique sous-marin (10) est déployé sous l'eau dans un état opérationnel, le dissipateur thermique (20) soit au moins partiellement immergé dans le liquide diélectrique (13),
dans lequel les ailettes du dissipateur thermique (20) sont alignées de telle manière que l'écoulement de fluide du courant de convection (16) soit parallèle à l'élongation des ailettes.

13. Le procédé selon la revendication 12, comprenant en outre l'étape de configuration du système électronique sous-marin (10) selon l'une quelconque des revendications 2 à 11.
